# EUROPEAN PATENT APPLICATION

(11) **EP 3 608 956 A1**
(43) Date of publication of application: **12.02.2020**
(21) Application number: 18794023.4
(22) Date of filing: 02.05.2018
(51) Int. Cl.: H01L 23/498, H01L 21/48

(54) **EMBEDDED SUBSTRATE AND MANUFACTURING METHOD THEREFOR**

(30) Priority: 05.05.2017 CN 201710313770
(71) Applicant: Huawei Technologies Co., Ltd., Longgang District Shenzhen, Guangdong 518129 (CN)
(72) Inventor: BAO, Kuanming, Shenzhen Guangdong 518129 (CN); WANG, Junhe, Shenzhen Guangdong 518129 (CN); HOU, Zhaozheng, Shenzhen Guangdong 518129 (CN)
(74) Representative: Goddar, Heinz J.
(86) International application number: PCT/CN2018/085337
(87) International publication number: WO 2018/202040

(57) **Abstract**

Embodiments of this application disclose an embedded substrate and a method for manufacturing an embedded substrate. The embedded substrate includes a substrate and a chip embedded in the substrate. A height value of the metal boss is greater than 100 micrometers is disposed at each pin on the chip. A drill hole is opened in a region corresponding to the metal boss on the substrate, and a conductive material is filled in the drill hole. A first surface of the substrate is disposed with a conductive layer satisfying a connection requirement of each pin. Pins having the connection requirement are connected by using the metal boss, the conductive material, and the conductive layer. In the embodiments, a particular distance is maintained between the drill hole and the chip by using the metal boss. In this way, even though the drill hole exceeds a range of the metal boss, a substrate material in an exceeded region may protect the chip from being damaged. Therefore, there is no need to limit a hole diameter of the drill hole. This expands a chip type selection scope for a substrate factory and an embedded-substrate factory selection scope for a chip provider, and helps save costs. In addition, the hole diameter of the drill hole may be increased as much as possible, to facilitate through-flow and heat dissipation of the embedded substrate.

## Description

This application claims priority to Chinese Patent Application No. 201710313770.5, filed with the Chinese Patent Office on May 5, 2017 and entitled "EMBEDDED SUBSTRATE AND MANUFACTURING METHOD FOR MANUFACTURING EMBEDDED SUBSTRATE", which is incorporated herein by reference in its entirety.

### TECHNICAL FIELD

This application relates to the field of electronic materials and component technologies, and in particular, to an embedded substrate and a method for manufacturing an embedded substrate.

### BACKGROUND

Embedded component packaging (ECP) is a packaging form in which electronic components such as a capacitor, a resistor, and a chip are embedded in a substrate. The embedded component packaging, which can shorten a link path between the components, reduce a transmission loss, improve product integration, reduce an outer dimension of a module, and improve reliability and electro-thermal performance of a product, is an important means of achieving multifunctionality and high performance of a portable electronic device.

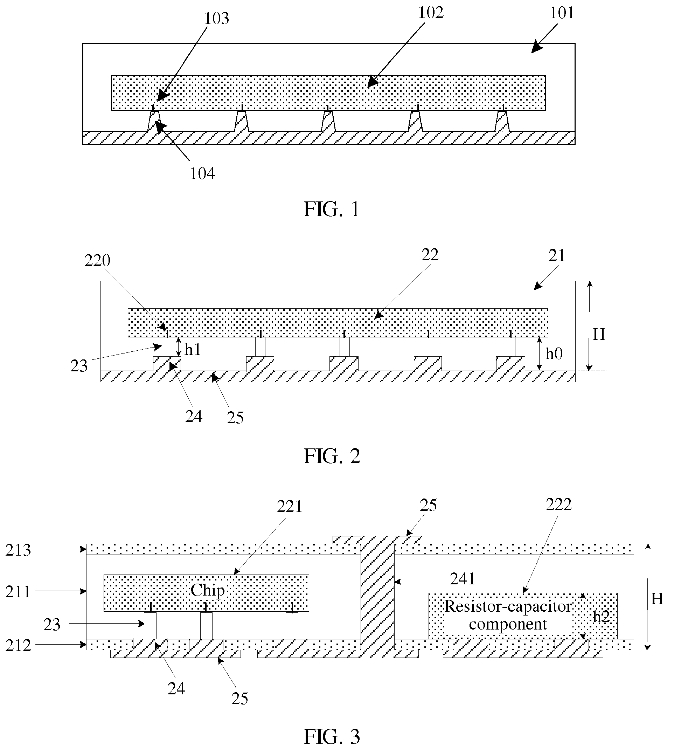

In an existing production process, the embedded component packaging is usually implemented by using drilling and plating processes. As shown in FIG. 1, FIG. 1 is a schematic structural diagram of an existing substrate based on the embedded component packaging (referred to as an embedded substrate hereinafter). A chip 102 required by the embedded substrate is embedded in a substrate 101. The chip 102 is disposed with various pins 1020, a plurality of drill holes 104 are disposed on the substrate 101 by using a drilling process, and a conductive material (for example, copper) is filled in the drill holes 104 by using a plating process or the like, so that the pins on a component 102 extend out of the substrate 101 by using the conductive material in the drill holes 104, to interconnect the chip 102 with another chip.

It can be learned that according to the existing embedded component packaging process, laser generated when the drill holes 104 are drilled damage the chip. In an actual machining process, a minimum hole diameter of a drill hole of a drilling device is limited by performance of the drilling device, and a drilling offset possibly caused by a deviation is controlled in a drilling process. Due to such limiting factors, for a chip having relatively dense pins, such as an integrated chip, pins disposed on the chip are also very dense. To avoid damaging the chip, drill holes cannot be excessive large or cannot be deviated in position. This is a difficulty in the existing drilling process.

### SUMMARY

Embodiments of this application provide an embedded substrate and a method for manufacturing an embedded substrate, so as to resolve a problem in an existing embedded component packaging process that a hole diameter of a drill hole cannot exceed a pad size of a chip.

According to a first aspect, an embodiment of this application provides an embedded substrate. The embedded substrate includes a substrate and a chip embedded in the substrate. A metal boss is disposed at a pin on the chip, and the pin is electrically connected to one end of the metal boss. A height direction of the metal boss is perpendicular to a plane in which the chip is located, and a height value of the metal boss is greater than 100 micrometers. A first surface of the substrate is disposed with a conductive layer matching a connection requirement of the pin. The first surface is a surface of the substrate that is parallel to the chip and that is closest to the metal boss. A drill hole is opened between the other end of the metal boss and the conductive layer on the substrate, and a conductive material is filled in the drill hole, to connect the pin having the connection requirement on the chip to the conductive layer by using the metal boss and the conductive material. A cross section of the drill hole exceeds a cross section range of the other end of the metal boss.

According to this implementation, when it is ensured that a pin on an electronic component embedded in the substrate is normally connected, because the metal boss has a particular height (greater than 100 micrometers), a particular distance may be maintained between the drill hole and the chip. In this way, even though the drill hole exceeds a top surface range of the metal boss, an exceeded region may have a substrate material whose thickness is the same as the height of the metal boss, to protect the chip from being damaged. Therefore, in an actual machining process of the embedded substrate provided in this embodiment of this application, there is no need to limit a hole diameter of the drill hole based on a pad size or a metal boss size. For an embedded-substrate factory, this embodiment of this application may be applied to expand a chip type selection scope. That is, embedded packaging may be performed on any chip, with no need to consider whether a minimum hole diameter that can be reached by a drilling device of the embedded-substrate factory is less than a pad size of a chip. For a chip provider, this embodiment of this application may be applied to expand an embedded-substrate factory selection scope, and a minimum hole diameter that can be reached by a drilling device of each embedded-substrate factory is no longer a main selection limiting factor. Therefore, selection may be performed depending only on a factor such as a quotation, thereby helping reduce chip packaging costs.

In addition, because the hole diameter of the drill hole in this embodiment of this application is not limited by the pad size or the metal boss size of the chip, in an actual packaging process, the hole diameter of the drill hole may be increased as much as possible, so as to improve through-flow and heat dissipation capabilities of the embedded substrate.

Optionally, the substrate includes an intermediate substrate layer configured to embed the chip and the metal boss, and a first surface substrate layer laminated on one surface of the intermediate substrate layer. An outer surface of the first surface substrate layer is used as the first surface, and is disposed with the conductive layer, and the drill hole is opened in a region corresponding to each metal boss on the first surface substrate layer.

Optionally, the substrate further includes a second surface substrate layer laminated on the other surface of the intermediate substrate layer.

Optionally, the intermediate substrate layer, the first surface substrate layer, and the second surface substrate layer each are machined from a resin. The conductive layer includes a metal plating layer.

Optionally, the embedded substrate further includes a resistor-capacitor component embedded in the substrate. A drill hole is opened between a connecting terminal of the resistor-capacitor component and the conductive layer, a conductive material is filled in the drill hole, and the connecting terminal of the resistor-capacitor component is connected to the conductive layer by using the conductive material in the corresponding drill hole.

The embedded substrate provided in this implementation is simple in structure, and a required process and material are easy to implement and obtain, without increasing manufacturing costs. Especially, the metal boss is disposed at the pin on the chip, resolving a problem in a conventional embedded component packaging process that a hole diameter of a drill hole is limited by a pad size of a chip, making a drilling operation more easily performed without damaging the chip, expanding the chip type selection scope for the substrate factory, expanding the embedded-substrate factory selection scope for the chip provider, and helping save chip packaging costs. In addition, because this embodiment of this application imposes no limitation on the hole diameter of the drill hole, the hole diameter can be increased as much as possible, to facilitate through-flow and heat dissipation of the embedded substrate.

According to a second aspect, an embodiment of this application further provides a method for manufacturing an embedded substrate. The method includes: disposing a metal boss at each pin on a chip required by the embedded substrate, and electrically connecting the pin to one end of the metal boss, where a height direction of the metal boss is perpendicular to a plane in which the chip is located, and a height value of the metal boss is greater than 100 micrometers; determining, based on a preset structure of the embedded substrate, relative positions of electronic components required by the embedded substrate, where the electronic components include the chip to be embedded; filling a substrate material between the electronic components whose relative positions are determined, to form a substrate, so that the electronic components and the metal boss are embedded in the substrate; disposing a conductive layer on a first surface of the substrate based on a connection requirement of each electronic component, where the first surface is a surface of the substrate that is parallel to the chip and that is closest to the metal boss; and opening a drill hole between the other end of the metal boss and the conductive layer on the substrate, and filling a conductive material in the drill hole, to connect a pin having a connection requirement on the chip to the conductive layer by using the metal boss and the conductive material, where a cross section of the drill hole exceeds a cross section range of the other end of the metal boss.

According to this implementation, the cross section of the drill hole exceeds the cross section range of the other end of the metal boss. Because the metal boss has a particular height, even though the cross section of the drill hole exceeds the cross section range of the other end of the metal boss, a substrate material having a substantial thickness protects the chip from being damaged. Therefore, according to this embodiment of this application, a mutual limitation between a pad size of a chip and a minimum hole diameter of a drill hole in the prior art can be eliminated. Persons skilled in the art may properly set a hole diameter of the drill hole based on factors such as drill hole density and chip heat dissipation.

Optionally, the filling a substrate material between the electronic components whose relative positions are determined, to form a substrate includes: filling the substrate material between the electronic components whose relative positions are determined, to form an intermediate substrate layer, so that the chip and the metal boss are embedded in the intermediate substrate layer; and laminating a substrate material on one surface of the intermediate substrate layer, to form a first surface substrate layer. The disposing a conductive layer on a first surface of the substrate based on a connection requirement of each electronic component includes: disposing the conductive layer on an outer surface of the first surface substrate layer based on the connection requirement of each electronic component.

Optionally, the opening a drill hole between the other end of the metal boss and the conductive layer on the substrate includes: determining a drilling depth corresponding to each metal boss based on an actual embedding depth of the chip in the substrate and a height value of each metal boss; and opening, based on the drilling depth, a drill hole in a region corresponding to each metal boss on the first surface substrate layer.

Optionally, the filling a substrate material between the electronic components whose relative positions are determined, to form a substrate further includes: laminating a substrate material on the other surface of the intermediate substrate layer, to form a second surface substrate layer.

Optionally, the electronic components further include a resistor-capacitor component. The method further includes: opening, based on an actual embedding depth of the resistor-capacitor component in the substrate, a drill hole in a region corresponding to a connecting terminal of the resistor-capacitor component on the substrate, and filling a conductive material in the drill hole, so that the connecting terminal of the resistor-capacitor component is connected to the conductive layer by using the conductive material in the corresponding drill hole.

According to the method for manufacturing an embedded substrate provided in this embodiment of this application, there is no need to limit a hole diameter of the drill hole based on a pad size or a metal boss size. For an embedded-substrate factory, this embodiment of this application may be applied to expand a chip type selection scope. That is, embedded packaging may be performed on any chip, with no need to consider whether a minimum hole diameter that can be reached by a drilling device of the embedded-substrate factory is less than a pad size of a chip. For a chip provider, this embodiment of this application may be applied to expand an embedded-substrate factory selection scope, and a minimum hole diameter that can be reached by a drilling device of each embedded-substrate factory is no longer a main selection limiting factor. Therefore, selection may be performed depending only on a factor such as a quotation, thereby helping reduce chip packaging costs. In addition, because the hole diameter of the drill hole in this embodiment of this application is not limited by the pad size or the metal boss size of the chip, in an actual packaging process, the hole diameter of the drill hole may be increased as much as possible, so as to improve through-flow and heat dissipation capabilities of the embedded substrate.

### BRIEF DESCRIPTION OF DRAWINGS

To describe technical solutions in this application more clearly, the following briefly describes the accompanying drawings that need to be used in the embodiments. Obviously, for persons of ordinary skill in the art, other drawings may be obtained according to these accompanying drawings without creative efforts.
FIG. 1 is a schematic structural diagram of an existing embedded substrate;
FIG. 2 is a schematic structural diagram of an embedded substrate according to an embodiment of this application;
FIG. 3 is a schematic structural diagram of another embedded substrate according to an embodiment of this application;
FIG. 4 is a flowchart of a method for manufacturing an embedded substrate according to an embodiment of this application; and
FIG. 5 is a schematic process flowchart of a method for manufacturing an embedded substrate according to an embodiment of this application.

### DESCRIPTION OF EMBODIMENTS

FIG. 2 is a schematic structural diagram of an embedded substrate according to an embodiment of this application, and more specifically, is a sectional view along a thickness direction of the embedded substrate. Referring to FIG. 2, the embedded substrate includes a substrate 21 and a chip 22 embedded in the substrate 21.

A metal boss 23 is disposed at each pin 220 on the chip 22, and the pin 220 is electrically connected to one end of the corresponding metal boss 23. A height direction of the metal boss 23 is perpendicular to a plane in which the chip 22 is located, and the height direction of the metal boss 23 is parallel to a thickness (H) direction of the substrate 21. A height value h1 of the metal boss 23 may be determined based on an embedding depth h0 of the chip 22 in the substrate 21. That is, a larger depth (larger h0) by which the chip is embedded indicates a larger height value h1 of the required metal boss. Optionally, in this embodiment, the height value h1 of each metal boss 23 is greater than 100 micrometers.

A first surface of the substrate 21 is disposed with a conductive layer 25 matching a connection requirement of the pin 220. The first surface is a surface of the substrate 21 that is parallel to the chip 22 and that is closest to the metal boss 23. A drill hole 24 is disposed between the other end of the metal boss 23 and the conductive layer 25 on the substrate 21, and a conductive material is filled in each drill hole 24. A cross-sectional area of the metal boss 23 is relatively small. Therefore, in this embodiment, a cross section of the drill hole 24 may exceed a cross section range of the other end of the metal boss 23. In this way, it can be ensured that a contact area of the other end of the metal boss 23 and the conductive material is not less than the cross-sectional area of the metal boss 23, thereby ensuring an effective connection between the metal boss and the conductive material.

According to the foregoing structure, in the substrate, one end of the metal boss 23 is connected to a corresponding pin 220, and another end is connected to a conductive material in a corresponding drill hole 24. In addition, on a surface of the substrate, the conductive material in the drill hole 24 is connected to the conductive layer, so that pins that are of a single chip or of a plurality of chips and that have the connection requirement on the embedded substrate implement a connection by using the metal boss and the conductive material. As shown in FIG. 2, interconnection among five pins is implemented.

The chip packaged in the foregoing structure may be a chip on which a pad has been disposed. That is, a metal boss maybe disposed on each pad, and then embedded packaging (including drilling, conductive material filling, conductive layer disposing, and the like) is performed on the chip. For a chip on which no pad is disposed, a metal boss may be directly disposed at each pin on the chip, and then embedded packaging is performed.

It can be learned that in this embodiment of this application, when a normal connection between the pins is ensured, because the metal boss has a particular height (greater than 100 micrometers), a particular distance may be maintained between a deepest point of the drill hole and the chip. In this way, even though the drill hole exceeds a top surface range of the metal boss (for example, the metal boss is a cylinder boss having a diameter of 110 um, and the drill hole has a hole diameter of 150 umm), an exceeded region may have a substrate material whose thickness is the same as the height of the metal boss, to protect the chip from being damaged. Therefore, in an actual machining process of the embedded substrate provided in this embodiment of this application, there is no need to limit a hole diameter of the drill hole based on a pad size or a metal boss size. For an embedded-substrate factory, this embodiment of this application may be applied to expand a chip type selection scope. That is, embedded packaging may be performed on any chip, with no need to consider whether a minimum hole diameter that can be reached by a drilling device of the embedded-substrate factory is less than a pad size of a chip. For a chip provider, this embodiment of this application may be applied to expand an embedded-substrate factory selection scope, and a minimum hole diameter that can be reached by a drilling device of each embedded-substrate factory is no longer a main selection limiting factor. Therefore, selection may be performed depending only on a factor such as a quotation, thereby helping reduce chip packaging costs.

For example, a pad size of a chip A provided by a chip provider is 110 um, a minimum hole diameter of a drill hole that can be reached by a substrate factory C is 110 um, a quotation is 0.074 dollar, a minimum hole diameter of a drill hole that can be reached by a substrate factory D is 150 um, and a quotation is 0.068 dollar. According to the prior art, only the substrate factory C providing a higher quotation can be selected to perform embedded packaging on the chip A. However, in this embodiment of this application, there is no need to consider the pad size or a size of an additionally disposed metal boss of the chip A and the minimum hole diameters that can be reached by the substrate factories, and the substrate factory D providing a lower quotation can be selected to perform embedded packaging on the chip A. Comparing with selecting the substrate factory C, packaging costs for each chip may be reduced by 0.006 dollar.

In addition, because the hole diameter of the drill hole in this embodiment of this application is not limited by the pad size or the metal boss size of the chip, in an actual packaging process, the hole diameter of the drill hole may be increased as much as possible, so as to improve through-flow and heat dissipation capabilities of the embedded substrate.

FIG. 3 is a schematic structural diagram of another embedded substrate according to an embodiment of this application. Compared with the structure shown in FIG. 2, FIG. 3 shows a specific structure of the substrate 21, including an intermediate substrate layer 211 and a first surface substrate layer 212 laminated on one surface of the intermediate substrate layer 211.

The intermediate substrate layer 211 is configured to embed the chip and the metal boss 23 of the chip. An end face of the other end of the metal boss 23 and the surface that is of the intermediate substrate layer 211 and on which the first surface substrate layer 212 is laminated are located in a same plane. That is, the end face of the metal boss 23 is exactly exposed on the surface of the intermediate substrate layer 211. The intermediate substrate layer 211 may be filled and formed between chips.

An outer surface of the first surface substrate layer 212 is used as the first surface (front face) of the embedded substrate, and is disposed with the conductive layer 25. The drill hole 24 is disposed in a region between the end face of the other end of the metal boss 23 and the conductive layer 25 on the first surface substrate layer 212. Because the end face of the metal boss 23 is exposed on the first surface of the intermediate substrate layer 211, the filled conductive material can be connected to the metal boss in the substrate provided that a drilling depth is not less than a thickness of the first surface substrate layer 212. In an actual machining process, even though the end face of the metal boss 23 is embedded in the intermediate substrate layer 211 instead of being exposed on the surface of the intermediate substrate layer 211, a connection between the metal boss and the conductive material can be ensured by increasing a drilling depth during drilling.

In a feasible embodiment of this application, the substrate 21 of the embedded substrate may further include a second surface substrate layer 213 laminated on the other surface of the intermediate substrate layer 211.

According to an actual application requirement, an outer surface of the second surface substrate layer 213 is used as a second surface (back face) of the embedded substrate, and may also be disposed with a conductive layer (usually used as a ground terminal). In addition, the drill hole may extend through the entire substrate 21, so that the first surface and the second surface of the embedded substrate are in communication with each other, such as a drill hole 241 in FIG. 3.

Still referring to FIG. 3, in a feasible embodiment of this application, in addition to a chip 221 having various functions, electronic components embedded in the embedded substrate may further include a resistor-capacitor component 222 (that is, electronic components such as a capacitor and a resistor). The resistor-capacitor component 222 is directly connected to the conductive material in the drill hole inside the substrate 21.

In this embodiment of this application, to keep drilling depths consistent, and facilitate uniform control during a drilling operation, it needs to be ensured that an embedding depth of a top surface of the metal boss in the substrate is the same as an embedding depth of a surface on which a connecting terminal of the resistor-capacitor component is located in the substrate. That is, it needs to be ensured that the surface on which the connecting terminal of the resistor-capacitor component 222 is coplanar with the surface that is of the intermediate substrate layer and on which the first surface substrate layer is laminated, that is, coplanar with the end face of the metal boss, as shown in FIG. 3. In view of this, the height h1 of the metal boss may be determined based on a maximum thickness h2 of the resistor-capacitor component to be embedded in the embedded substrate. A larger thickness h2 of the resistor-capacitor component indicates a larger substrate thickness required for performing embedded packaging. The height h1 of the metal boss may be set to a larger value, to protect, to a greater extent, the chip from being damaged.

In a feasible embodiment of this application, a basic material used for the intermediate substrate layer, the first surface substrate layer, and the second surface substrate layer may be specifically a resin. The conductive layer on the surface of the substrate may be a metal plating layer, for example, a copper plating layer, that is, a metal wiring layer that satisfies a connection requirement of each pin on the embedded substrate and that is machined by using a plating process. The conductive material in the drill hole may also be copper, and specifically, may be filled by using a plating process, so that the electronic components (including the chip and the resistor-capacitor component) of the embedded substrate are connected to form a circuit having a particular function.

It can be learned from the foregoing embodiment that the embedded substrate provided in this embodiment of this application is simple in structure, and a required process and material are easy to implement and obtain, without increasing manufacturing costs. Especially, the metal boss is disposed at the pin on the chip, resolving a problem in a conventional embedded component packaging process that a hole diameter of a drill hole is limited by a pad size of a chip, making a drilling operation more easily performed without damaging the chip, expanding the chip type selection scope for the substrate factory, expanding the embedded-substrate factory selection scope for the chip provider, and helping save chip packaging costs. In addition, because this embodiment of this application imposes no limitation on the hole diameter of the drill hole, the hole diameter can be increased as much as possible, to facilitate through-flow and heat dissipation of the embedded substrate.

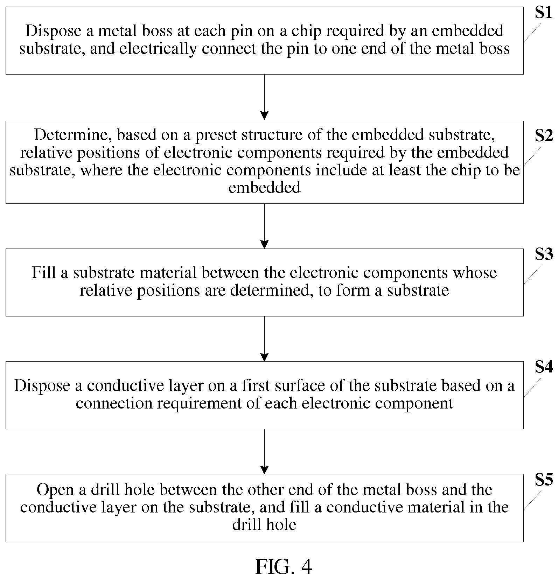

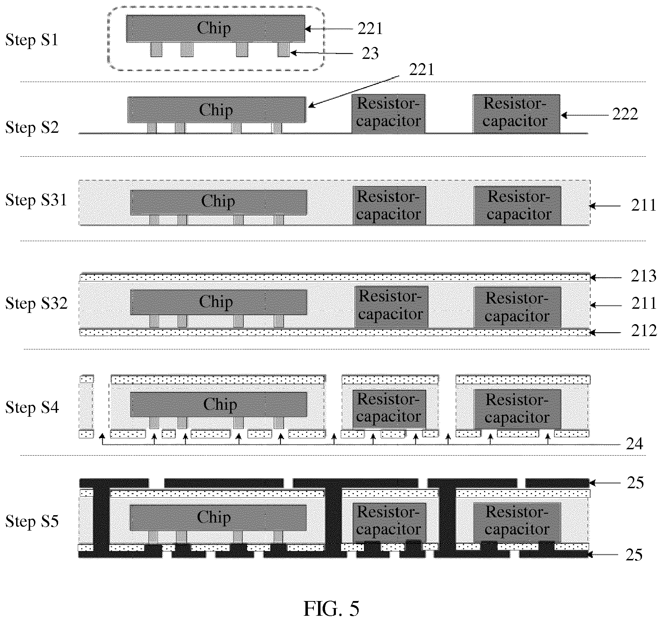

Based on the foregoing structures, an embodiment of this application further provides a method for manufacturing an embedded substrate. FIG. 4 is a flowchart of the method for manufacturing an embedded substrate, and FIG. 5 is a schematic process flowchart corresponding to the method.

Referring to FIG. 4 and FIG. 5, the method for manufacturing an embedded substrate includes the following steps.

Step S1. Dispose a metal boss at each pin on a chip required by the embedded substrate, and electrically connect the pin to one end of the metal boss.

For a chip 221 and a metal boss 23 required by the embedded substrate shown in FIG. 5, a height direction of the metal boss 23 is perpendicular to a plane in which the chip 221 is located. In this embodiment, a height value of the metal boss 23 is greater than 100 micrometers.

Step S2. Determine, based on a preset structure of the embedded substrate, relative positions of electronic components required by the embedded substrate.

As shown in FIG. 5, the electronic components include at least the chip 221. In some feasible embodiments of this application, the electronic components may further include a resistor-capacitor component 222.

Step S3. Fill a substrate material between the electronic components whose relative positions are determined, to form a substrate.

The electronic components are placed on a machining table based on the preset structure of the embedded substrate, and the relative positions of the electronic components are fixed. Then, a basic material is filled between the electronic components, to form the substrate. In addition, the electronic components and the metal boss can be embedded in the substrate.

Step S4. Dispose a conductive layer on a first surface of the substrate based on a connection requirement of each electronic component.

The first surface may be a surface of the substrate that is parallel to the chip and that is closest to the metal boss. For details, refer to FIG. 2 to FIG. 4.

Step S5. Open a drill hole between the other end of the metal boss and the conductive layer on the substrate, and fill a conductive material in the drill hole.

In this embodiment, the conductive material in the drill hole is connected to an end face of the metal boss in the substrate, and is connected to the conductive layer on the first surface of the substrate, so that each pin is connected to the conductive layer by using the metal boss and the conductive material, thereby implementing a connection between different pins having the connection requirement. As shown in FIG. 5, four pins on the chip each are driven to the first surface of the embedded substrate by using the metal boss and the conductive material in the drill hole, connecting terminals of two resistor-capacitor components are also driven to the first surface of the embedded substrate by using the conductive material in the drill hole, and the pins and the connecting terminals are connected to other pins on the first surface of the embedded substrate by using a conductive layer 25.

In a feasible embodiment of this application, to keep drilling depths consistent, and facilitate uniform control during a drilling operation, it needs to be ensured that an embedding depth of an end face of the other end of the metal boss in the substrate is the same as an embedding depth of a surface on which a connecting terminal of the resistor-capacitor component is located in the substrate. That is, it needs to be ensured that the surface on which a connecting terminal of the resistor-capacitor component 222 is located is coplanar with a top surface of the metal boss in an intermediate substrate layer. Optionally, in this embodiment of this application, a height of the metal boss may be determined based on a maximum thickness of the resistor-capacitor component to be embedded in the embedded substrate. A larger thickness of the resistor-capacitor component indicates a larger substrate thickness required for performing embedded packaging. The height of the metal boss may be set to a larger value, to protect, to a greater extent, the chip from being damaged.

In this embodiment, a cross section of the drill hole exceeds a cross section range of the other end of the metal boss. Because the metal boss has a particular height, even though the cross section of the drill hole exceeds the cross section range of the other end of the metal boss, a substrate material having a substantial thickness protects the chip from being damaged. Therefore, according to this embodiment of this application, a mutual limitation between a pad size of a chip and a minimum hole diameter of a drill hole in the prior art can be eliminated. Persons skilled in the art may properly set a hole diameter of the drill hole based on factors such as drill hole density and chip heat dissipation. A plurality of drill holes 24 shown in FIG. 5 each have a hole diameter greater than a top surface diameter of the metal boss. In addition, because the other end of the metal boss has a relatively small cross-sectional area, in this embodiment, the cross section of the drill hole exceeds the cross section range of the other end of the metal boss. It can be ensured that a contact area of the other end of the metal boss and the conductive material is not less than the cross-sectional area of the other end of the metal boss, thereby ensuring an effective connection between the metal boss and the conductive material.

It can be learned that in an actual machining process of the embedded substrate provided in this embodiment of this application, there is no need to limit a hole diameter of the drill hole based on a pad size or a metal boss size. For an embedded-substrate factory, this embodiment of this application may be applied to expand a chip type selection scope. That is, embedded packaging may be performed on any chip, with no need to consider whether a minimum hole diameter that can be reached by a drilling device of the embedded-substrate factory is less than a pad size of a chip. For a chip provider, this embodiment of this application may be applied to expand an embedded-substrate factory selection scope, and a minimum hole diameter that can be reached by a drilling device of each embedded-substrate factory is no longer a main selection limiting factor. Therefore, selection may be performed depending only on a factor such as a quotation, thereby helping reduce chip packaging costs.

In addition, because the hole diameter of the drill hole in this embodiment of this application is not limited by the pad size or the metal boss size of the chip, in an actual packaging process, the hole diameter of the drill hole may be increased as much as possible, so as to improve through-flow and heat dissipation capabilities of the embedded substrate.

Referring to FIG. 5, in a feasible embodiment of this application, step S3 of filling a substrate material between the electronic components whose relative positions are determined, to form a substrate may specifically include the following steps.

Step S31. Fill the substrate material between the electronic components whose relative positions are determined, to form an intermediate substrate layer 211.

The resistor-capacitor component, the chip, and the metal boss are embedded in the intermediate substrate layer 211 by filling the substrate material.

Step S32. Laminate a substrate material on a first surface of the intermediate substrate layer 211, to form a first surface substrate layer 212.

In a feasible embodiment, step S32 may further include: laminating a substrate material on a second surface of the intermediate substrate layer 211, to form a second surface substrate layer 213.

Based on step S32, the drilling process in step S4 may be specifically performed on the first surface substrate layer 212. In addition, the conductive layer in step S5 may also be disposed on the outer surface of the first surface substrate layer 212. As shown in FIG. 5, in some feasible embodiments, the surface of the second surface substrate layer 213 may also be disposed with a conductive layer, and the conductive layer is connected to the conductive layer on the outer surface of the first surface substrate layer by using the drill hole extending through the entire substrate.

In a feasible embodiment, when step S31 of filling the substrate material to form the intermediate substrate layer 211 is performed, the top surface of the metal boss and the surface on which the connecting terminal of the resistor-capacitor component is located may be controlled to be coplanar with the first surface of the intermediate substrate layer 211. Therefore, in step S4, drilling depths of the drill holes may be kept consistent with the thickness of the first surface substrate layer 212, to facilitate uniform control during a drilling operation.

In another feasible embodiment, alternatively, the drilling depths may not be the same. When step S4 is performed, first, a drilling depth corresponding to each metal boss is determined based on an actual embedding depth of the chip in the substrate and a height value of each metal boss, and then, a drill hole is opened, based on the determined drilling depth, in a region corresponding to each metal boss on the first surface substrate layer and/or a region of the connecting terminal of the resistor-capacitor component.

The substrate material used in this embodiment of this application may be a resin. The metal boss may be specifically machined from copper. The conductive material and the conductive layer may also use metal copper, and machined by using a plating process.

It can be learned that the material used in the process of manufacturing an embedded substrate provided in this embodiment of this application is easy to obtain, and a used process technology is easy to implement. Especially, a mutual limitation between a pad size of a chip and a minimum hole diameter of a drill hole in the prior art is eliminated. This can increase the hole diameter of the drill hole as much as possible within an allowable range of drill hole density. On one hand, this reduces a performance requirement on a drilling device. On the other hand, this can improve through-flow and heat dissipation capabilities of the formed embedded substrate.

For same or similar parts in the embodiments in this specification, reference may be made to these embodiments. The foregoing implementations of the present invention do not constitute a limitation on the protection scope of the present invention.

## Claims

1. An embedded substrate, comprising a substrate and a chip embedded in the substrate, wherein
a metal boss is disposed at a pin on the chip, and the pin is electrically connected to one end of the metal boss, wherein a height direction of the metal boss is perpendicular to a plane in which the chip is located, and a height value of the metal boss is greater than 100 micrometers;
a first surface of the substrate is disposed with a conductive layer matching a connection requirement of the pin, wherein the first surface is a surface of the substrate that is parallel to the chip and that is closest to the metal boss; and
a drill hole is opened between the other end of the metal boss and the conductive layer on the substrate, and a conductive material is filled in the drill hole, to connect the pin having the connection requirement on the chip to the conductive layer by using the metal boss and the conductive material, wherein a cross section of the drill hole exceeds a cross section range of the other end of the metal boss.

2. The embedded substrate according to claim 1, wherein the substrate comprises an intermediate substrate layer configured to embed the chip and the metal boss, and a first surface substrate layer laminated on one surface of the intermediate substrate layer; and
an outer surface of the first surface substrate layer is used as the first surface, and is disposed with the conductive layer, and the drill hole is opened in a region corresponding to each metal boss on the first surface substrate layer.

3. The embedded substrate according to claim 2, wherein the substrate further comprises a second surface substrate layer laminated on the other surface of the intermediate substrate layer.

4. The embedded substrate according to claim 3, wherein the intermediate substrate layer, the first surface substrate layer, and the second surface substrate layer each are machined from a resin; and
the conductive layer comprises a metal plating layer.

5. The embedded substrate according to any one of claims 1 to 4, further comprising a resistor-capacitor component embedded in the substrate, wherein
a drill hole is opened between a connecting terminal of the resistor-capacitor component and the conductive layer, a conductive material is filled in the drill hole, and the connecting terminal of the resistor-capacitor component is connected to the conductive layer by using the conductive material in the corresponding drill hole.

6. The embedded substrate according to claim 5, wherein a pad is disposed between the pin and the metal boss, and the pad is configured to weld the pin and the metal boss.

7. A method for manufacturing an embedded substrate, comprising:
disposing a metal boss at each pin on a chip required by the embedded substrate, and electrically connecting the pin to one end of the metal boss, wherein a height direction of the metal boss is perpendicular to a plane in which the chip is located, and a height value of the metal boss is greater than 100 micrometers;
determining, based on a preset structure of the embedded substrate, relative positions of electronic components required by the embedded substrate, wherein the electronic components comprise the chip to be embedded;
filling a substrate material between the electronic components whose relative positions are determined, to form a substrate, so that the electronic components and the metal boss are embedded in the substrate;
disposing a conductive layer on a first surface of the substrate based on a connection requirement of each electronic component, wherein the first surface is a surface of the substrate that is parallel to the chip and that is closest to the metal boss; and
opening a drill hole between the other end of the metal boss and the conductive layer on the substrate, and filling a conductive material in the drill hole, to connect a pin having a connection requirement on the chip to the conductive layer by using the metal boss and the conductive material, wherein a cross section of the drill hole exceeds a cross section range of the other end of the metal boss.

8. The method according to claim 7, wherein the filling a substrate material between the electronic components whose relative positions are determined, to form a substrate comprises:
filling the substrate material between the electronic components whose relative positions are determined, to form an intermediate substrate layer, wherein the chip and the metal boss are embedded in the intermediate substrate layer; and
laminating a substrate material on one surface of the intermediate substrate layer, to form a first surface substrate layer; and
the disposing a conductive layer on a first surface of the substrate based on a connection requirement of each electronic component comprises:
disposing the conductive layer on an outer surface of the first surface substrate layer based on the connection requirement of each electronic component.

9. The method according to claim 8, wherein the opening a drill hole between the other end of the metal boss and the conductive layer on the substrate comprises:
determining a drilling depth corresponding to each metal boss based on an actual embedding depth of the chip in the substrate and a height value of each metal boss; and
opening, based on the drilling depth, a drill hole in a region corresponding to each metal boss on the first surface substrate layer.

10. The method according to claim 9, wherein the filling a substrate material between the electronic components whose relative positions are determined, to form a substrate further comprises:
laminating a substrate material on the other surface of the intermediate substrate layer, to form a second surface substrate layer.

11. The method according to any one of claims 8 to 10, wherein the electronic components further comprise a resistor-capacitor component; and
the method further comprises:
opening, based on an actual embedding depth of the resistor-capacitor component in the substrate, a drill hole in a region corresponding to a connecting terminal of the resistor-capacitor component on the substrate, and filling a conductive material in the drill hole, so that the connecting terminal of the resistor-capacitor component is connected to the conductive layer by using the conductive material in the corresponding drill hole.
